# EUROPÄISCHE PATENTSCHRIFT

(11) **EP 2 839 544 B1**
(45) Veröffentlichungstag und Bekanntmachung des Hinweises auf die Patenterteilung: **25.04.2018**
(21) Anmeldenummer: 13756898.6
(22) Anmeldetag: 04.09.2013
(51) Int. Cl.: H01R 9/26, H01R 31/08

(54) **PRÜFKLEMMENBLOCK**
TEST TERMINAL BLOCK
BORNIER DE TEST

(30) Priorität: 04.09.2012 DE 102012017429
(43) Veröffentlichungstag der Anmeldung: 25.02.2015
(73) Patentinhaber: Phoenix Contact GmbH & Co. KG, 32825 Blomberg (DE)
(72) Erfinder: KLOPPENBURG, Christian, 33142 Büren Wewelsburg (DE)
(74) Vertreter: Gesthuysen Patent- und Rechtsanwälte
(86) Internationale Anmeldenummer: PCT/EP2013/068210
(87) Internationale Veröffentlichungsnummer: WO 2014/037358

(56) Entgegenhaltungen:
- DE-A1-102006 052 894
- DE-B3-102005 025 108

## Beschreibung

Die Erfindung betrifft einen Prüfklemmenblock bestehend aus einem Reihenklemmenblock und einem auf den Reihenklemmenblock aufsteckbaren Prüfsteckerblock, wobei der Reihenklemmenblock eine Mehrzahl von nebeneinander angeordneten Reihenklemmen und auf beiden Seiten der Mehrzahl von Reihenklemmen je eine Befestigungsklemme aufweist, wobei der Prüfsteckerblock eine Mehrzahl von miteinander verbundenen Prüfsteckern und auf beiden Seiten der Mehrzahl von Prüfsteckern je ein Befestigungsteil aufweist, wobei die beiden Befestigungsteile über ein Griffstück miteinander verbunden sind, wobei jede Reihenklemme zwei Strombalken aufweist, die zusammen eine Trennstelle bilden und wobei jeder Prüfstecker einen in eine Trennstelle einsteckbaren Kontaktstecker aufweist, und wobei die beiden Befestigungsklemmen jeweils ein Klemmengehäuse mit einer Führungsnut und die beiden Befestigungsteile jeweils ein Gehäuse mit einem korrespondierenden, in eine Führungsnut einsteckbaren Führungsabschnitt aufweisen. Daneben betrifft die Erfindung noch eine Baugruppe aus einer Befestigungsklemme und einem mit einem Prüfsteckerblock verbindbaren Befestigungsteil zur Verwendung bei einem Prüfklemmenblock.

Elektrische Reihenklemmen sind seit Jahrzehnten bekannt und werden millionenfach bei der Verdrahtung elektrischer Anlagen und Geräte verwendet. Die Klemmen werden meist auf Tragschienen aufgerastet, welche ihrerseits häufig in einer Mehrzahl in einem Schaltschrank angeordnet sind. Als Leiteranschlußelemente werden in Reihenklemmen überwiegend Schraubklemmen oder Zugfederklemmen verwendet. Das Klemmprinzip bei Zugfederklemmen ist ähnlich dem der Schraubtechnik. Während bei der Schraubklemme eine Zughülse durch die Betätigung der Klemmenschraube den Leiter gegen den Strombalken zieht, wird bei der Zugfederklemme diese Aufgabe von der Zugfeder übernommen. Daneben können aber auch Schneidanschlußklemmen oder Schenkelfederklemmen verwendet werden.

In der Schalt-, Meß- und Regeltechnik sind Durchgangsklemmen mit Trennmöglichkeit der Standard. Die bei der elektrischen Reihenklemme realisierte Trennmöglichkeit, d. h. die in dem Strombalken vorgesehene Trennstelle ermöglicht es dabei, unterschiedliche Stecker mit unterschiedlichen Funktionen in das Klemmengehäuse der Reihenklemme einzustecken, die dann an der Trennstelle den Strombalken kontaktieren. Als Stecker können dabei neben einfachen Trennsteckern oder Durchgangsverbindern insbesondere auch Prüfstecker verwendet werden, die spezielle Bauelemente aufweisen können und ein Überprüfen der ordnungsgemäßen Funktion des an die Reihenklemme angeschlossenen Stromkreises ermöglichen.
Elektrische Reihenklemmen, die in der Regel scheibenförmig ausgebildet sind, werden häufig mit mehreren anderen elektrischen Reihenklemmen zu einem Reihenklemmenblock zusammengesteckt und auf eine Tragschiene aufgerastet oder in einem Wandausschnitt, beispielsweise eines Schaltschranks, montiert. Entsprechend werden auch die einzelnen Prüfstecker, die in ihrer Breite in der Regel der Breite der Reihenklemmen entsprechen, zu einem Prüfsteckerblock verbunden und gemeinsam auf einen korrespondierenden Reihenklemmenblock aufgesetzt. Hierbei besteht die Anforderung, dass die Anzahl der miteinander verbundenen Reihenklemmen sowie die Anzahl der miteinander zu einem Prüfsteckerblock zusammengefassten Prüfstecker frei wählbar ist. Gleichzeitig sollen jedoch die zu einem Prüfsteckerblock zusammengefassten Prüfstecker möglichst einfach gemeinsam betätigt, d. h. gemeinsam auf den Reihenklemmenblock aufgesteckt werden können.

Aus der DE 10 2005 025 108 B3 ist eine Vorrichtung zum Testen einer Schutz-, Mess- oder Zähleinrichtung, beispielsweise eines Netzschutzrelais bekannt, die eine an die elektrische Einrichtung anschließbare Polleiste mit mehreren hintereinander angeordneten Polöffnungen und einen Steckerblock mit einer der Anzahl der Polöffnungen entsprechenden Anzahl von Polzungen aufweist. Ein einzelnes Polleistenmodul der Polleiste besteht dabei aus einem Gehäuse, in dem zwei Kontaktbuchsen zum Anschluss der Leitungen und mit den Kontaktbuchsen verbundene federbelastete Kontaktlaschen angeordnet sind. Die beiden Kontaktlaschen können dabei durch die Polzunge eines Steckers kontaktiert werden, wobei die Polzunge des Steckers zwei Polstege aufweist, die durch einen Isoliersteg voneinander getrennt sind. Der Isoliersteg bildet dabei zusammen mit der korrespondierenden Polöffnung im Polleistenmodul eine Codierung, die sicherstellt, dass nur ein Stecker mit einer bestimmten Polzunge in eine bestimmte Polöffnung einer Polleiste einführbar ist.

Im nicht eingesteckten Zustand des Steckers bzw. der Polzunge in die Polleiste kontaktieren die beiden Kontaktlaschen einander, so dass die beiden Kontaktbuchsen elektrisch leitend miteinander verbunden sind und über eine angeschlossene Polleiste Strom fließen kann. Ist der Stecker mit seiner Polzunge vollständig in die Polöffnung eingeschoben, so sind die beiden Kontaktlaschen elektrisch voneinander getrennt und der Stromfluss wird über den Stecker geführt, so dass ein Testvorgang durchgeführt werden kann.

Die DE 10 2006 052 894 A1 offenbart eine Reihenklemme, ein Prüfstecker und ein aus einer Mehrzahl von nebeneinander angeordneten Reihenklemmen und einer entsprechenden Anzahl von Prüfsteckern bestehenden Prüfklemmblock, wobei die einzelnen Reihenklemmen und die einzelnen Prüfstecker vom Grundprinzip ähnlich zu den aus der DE 10 2005 025 108 B3 bekannten Polleistenmodulen und Polsteckern sind.
Durch die Verwendung von zwei Befestigungsklemmen und zwei Befestigungsteilen, die jeweils auf beiden Seiten des Reihenklemmenblocks bzw. des Prüfsteckerblocks angeordnet sind, ist die Anzahl der Reihenklemmen sowie die Anzahl der Prüfstecker, die zu einem Reihenklemmenblock bzw. einem Prüfsteckerblock zusammengefasst werden können, frei wählbar. Die beiden Befestigungsteile sind über ein Griffstück miteinander verbunden, so dass der Prüfsteckerblock zusammen mit den beiden Befestigungsteilen einfach und bequem mit Hilfe des Griffstückes in den Reihenklemmenblock und die beiden Befestigungsklemmen ein- bzw. aufgesteckt werden kann. Das Griffstück ist dabei am oberen Ende der Befestigungsteile angeordnet, die eine größere Höhe als die Prüfstecker aufweisen, so dass das Griffstück die zwischen den beiden Befestigungsteilen angeordneten Prüfstecker überspannt und dadurch bequem mit einer Hand gegriffen werden kann.

Um beim Einstecken des Prüfsteckers in die Prüföffnung definierte Kontaktzustände zu gewährleisten, sind bei der aus der DE 10 2006 052 894 A1 bekannten elektrischen Reihenklemme die Strombalken so ausgebildet, dass sie zwei Kontaktbereiche bilden, die in Aufsteckrichtung eines Prüfsteckers hintereinander angeordnet sind. Bei den bekannten Reihenklemmen ist somit die von den einen Endbereichen der Stromschienen gebildete Trennstelle zweistufig ausgebildet. Durch die Ausbildung eines definierten zweiten Kontaktbereichs, der in Einführrichtung des Kontaktsteckers vor dem ersten Kontaktbereich angeordnet ist, ist gewährleistet, dass es beim Einführen des Kontaktsteckers zunächst zu einer sicheren elektrischen Verbindung zwischen dem Kontaktstecker und den beiden Strombalken kommt, bevor der erste Kontaktbereich beim weiteren Einführen des Kontaktsteckers geöffnet wird, wodurch die beiden Strombalken dann elektrisch voneinander getrennt werden.
Den zuvor beschriebenen, bekannten Reihenklemmen bzw. Prüfklemmblöcken ist gemeinsam, dass die beiden Strombalken einander kontaktieren, so dass die Leiteranschlusselemente elektrisch leitend miteinander verbunden sind, wenn kein Stecker in die Reihenklemme eingesteckt ist. Ist dagegen ein Stecker (vollständig) in die Reihenklemme eingesteckt, so ist der Kontaktbereich aufgetrennt, so dass auch die Leiteranschlusselemente elektrisch voneinander getrennt sind.

Häufig weisen dabei die einzelnen Prüfstecker des Prüfsteckerblocks unterschiedlich lange Kontaktstecker auf. Beim Aufstecken des Prüfsteckerblocks tauchen dann zunächst die längeren Kontaktstecker einzelner Prüfstecker in die korrespondierenden Öffnungen im Klemmengehäuse der Reihenklemmen ein und kontaktieren dort den in Aufsteckrichtung des Prüfsteckers ersten, voreilenden Kontaktbereich der beiden Strombalken. Wird der Prüfsteckerblock weiter auf den Reihenklemmenblock aufgesteckt, so tauchen die längeren Kontaktstecker in den zweiten Kontaktbereich ein, wodurch dieser Kontaktbereich geöffnet wird, so dass die elektrisch leitende Verbindung zwischen den beiden Strombalken - und damit auch zwischen den beiden mit den Strombalken verbundenen Leiteranschlusselementen - unterbrochen wird. Sind die Kotaktstecker elektrisch leitend, so wird dadurch die Stromführung über den Prüfstecker umgeleitet. Wird der Prüfsteckerblock weiter auf den Reihenklemmenblock aufgesteckt, so kontaktieren als nächstes die kürzeren Kontaktstecker zunächst entsprechend den voreilenden Kontaktbereich in den Reihenklemmen, bevor auch die kürzeren Kontaktstecker den zweiten Kontaktbereich öffnen und dadurch auch die Stromführung dieser Reihenklemmen unterbrochen und ggf. über die Prüfstecker umgeleitet wird.

Beim Herausziehen des Prüfsteckerblocks aus dem Reihenklemmenblock ist es bei vielen Anwendungsfällen erforderlich oder zumindest gewünscht, dass die längeren Kontaktstecker den Kontaktbereich der zugeordneten Reihenklemmen noch auftrennen, während die kürzeren Kontaktstecker schon aus dem zweiten Kontaktbereich der zugeordneten Reihenklemmen herausgezogen sind, so dass sich die beiden Strombalken der entsprechenden Reihenklemme wieder kontaktieren, wodurch die Stromführung über die Reihenklemme erfolgt. Hierbei besteht bei den bekannten Prüfklemmenblöcken jedoch die Gefahr, dass durch ein zu schnelles oder ungleichmäßiges Herausziehen des Prüfsteckerblocks aus dem Reihenklemmenblock die zuvor beschriebene Abfolge, wonach die Kontaktbereiche einiger Reihenklemmen durch die längeren Kontaktstecker noch geöffnet sind, während über andere Reihenklemmen, denen Prüfstecker mit kürzeren Kontaktsteckern zugeordnet sind, bereits ein Stromübergang erfolgt, nicht sicher oder einwandfrei gewährleistet ist. Hierdurch kann sich ein instabiler bzw. undefinierter elektronischer Zustand einzelner Reihenklemmen des Reihenklemmenblocks ergeben.

Der vorliegenden Erfindung liegt die Aufgabe zugrunde, einen Prüfklemmenblock anzugeben, bei dem die zuvor beschriebenen Nachteile vermieden werden. Vorzugsweise soll darüber hinaus das Herausziehen eines Prüfsteckerblocks aus einem Reihenklemmenblock für einen Benutzer möglichst einfach und komfortabel sein.

Diese Aufgabe ist bei dem eingangs beschriebenen Prüfklemmenblock mit den Merkmalen des Patentanspruchs 4 dadurch gelöst, dass die Klemmengehäuse der beiden Befestigungsklemmen jeweils mindestens zwei Rastelemente und die Gehäuse der beiden Befestigungsteile jeweils mindestens zwei korrespondierende Gegenrastelemente aufweisen, wobei die Rastelemente und die Gegenrastelemente zusammen zwei in Aufsteckrichtung der Befestigungsteile bzw. des Prüfsteckers hintereinander angeordnete Rastpositionen der Befestigungsteile in den Befestigungsklemmen festlegen. Erfindungsgemäß sind durch die Ausbildung der Rastelemente und der korrespondierenden Gegenrastelemente somit eine erste Rastposition und eine zweite Rastposition realisiert, wodurch der Prüfsteckerblock sowohl in seiner vollständig aufgesteckten Position als auch in einer zweiten, teilweise herausgezogenen Position verriegelt werden kann. Durch die zweite Rastposition kann dabei sichergestellt werden, dass der Prüfsteckerblock zunächst nur so weit aus dem Reihenklemmenblock herausgezogen wird, dass kürzere Kontaktstecker einzelner Prüfstecker die Kontaktbereiche der zugeordneten Reihenklemmen nicht mehr öffnen, während die Kontaktbereiche anderer Reihenklemmen durch die längeren Kontaktstecker der diesen Reihenklemmen zugeordneten Prüfstecker noch geöffnet sind.
Um eine gewollte Entriegelung der beiden Rastpositionen zu ermöglichen, ist im Gehäuse der beiden Befestigungsteile jeweils ein Entriegelungselement verschiebbar angeordnet, das in eine erste und in eine zweite Entriegelungsposition verbringbar ist, wobei in der ersten Entriegelungsposition die Verriegelung der ersten Rastposition und in der zweiten Entriegelungsposition die Verriegelung der zweiten Rastposition durch das Entriegelungselement gelöst wird. Wird das Entriegelungselement in die erste Entriegelungsposition gebracht, so wird also die Verriegelung zwischen den Rastelementen und den Gegenrastelementen der ersten Rastposition gelöst, so dass der Prüfsteckerblock etwas aus dem Reihenklemmenblock heraus gezogen werden kann. Da das Herausziehen des Prüfsteckerblocks aus dem Reihenklemmenblock durch die zweite Rastposition begrenzt wird, muss zum vollständigen Herausziehen des Prüfsteckerblocks aus dem Reihenklemmenblock zunächst das Entriegelungselement in die zweite Entriegelungsposition verbracht werden, wodurch die zweite Rastposition gelöst wird, so dass dann der Prüfsteckerblock vollständig aus dem Reihenklemmenblock herausgezogen werden kann.

Gemäß einer ersten, besonders vorteilhaften Ausgestaltung der Erfindung ist das Entriegelungselement derart ausgebildet und innerhalb des Gehäuses des Befestigungsteils angeordnet, dass die Unterkante des Entriegelungselements in der ersten Entriegelungsposition auf der Oberseite des Klemmengehäuses der Befestigungsklemme aufsitzt, und dass das Entriegelungselement aus dieser ersten Entriegelungsposition in Aufsteckrichtung des Befestigungsteils weiter in eine dritte Position verschiebbar ist, wodurch das Gehäuse des Befestigungsteils von dem Klemmengehäuse der Befestigungsklemme abgestoßen wird. Durch diese Ausgestaltung des Entriegelungselements fungiert dieses nicht nur zum Entriegeln der beiden Rastpositionen, sondern darüber hinaus auch als Auswurf- bzw. Abziehhilfe beim Herausziehen des Prüfsteckerblocks aus dem Reihenklemmenblock.

Insbesondere dann, wenn ein Prüfklemmenblock eine etwas größere Anzahl von Reihenklemmen und Prüfsteckern aufweist, können sich durch die einzelnen Federkräfte der Trennstellen in den Reihenklemmen relativ hohe Ziehkräfte beim Herausziehen des Prüfsteckerblocks aus dem Reihenklemmenblock ergeben. Diese manuell vom Benutzer aufzubringenden Ziehkräfte können durch die zuvor beschriebene bevorzugte Ausgestaltung des erfindungsgemäßen Prüfklemmenblocks verringert werden, da das Gehäuse des Befestigungsteils von dem Klemmengehäuse der Befestigungsklemme - und damit auch die einzelnen Prüfstecker von den einzelnen Reihenklemmen - abgestoßen werden, wenn das Entriegelungselement aus der ersten Entwicklungsposition, in der es bereits auf der Oberseite des Klemmengehäuses der Befestigungsklemme aufsitzt, weiter in eine dritte Position verbracht wird. Das Entriegelungselement unterstützt somit den Benutzer beim Herausziehen des Prüfsteckerblocks aus dem Reihenklemmenblock, so dass dieser dafür nur noch weniger Kraft aufbringen muss.

Gemäß einer weiteren vorteilhaften Ausgestaltung des erfindungsgemäßen Prüfklemmenblocks sind die Rastelemente im Klemmengehäuse der Befestigungsklemmen als Rastlaschen und die Gegenrastelemente am Gehäuse der Befestigungsteile als korrespondierende Rasthaken ausgebildet. Die mindestens eine Rastlasche der ersten Rastposition und die mindestens eine Rastlasche der zweiten Rastposition sind dabei vorzugsweise auf gegenüberliegenden Seiten des Klemmengehäuses und in unterschiedlichen Ebenen in Aufsteckrichtung der Befestigungsteile angeordnet. Durch die Anordnung der Rastlaschen in unterschiedlichen Ebenen in Aufsteckrichtung der Befestigungsteile können auf einfache Art und Weise die zwei in Aufsteckrichtung hintereinander angeordneten Rastpositionen realisiert werden. Durch die Anordnung der Rastlaschen auf gegenüberliegenden Seiten des Klemmengehäuses ist ein einfaches Lösen der beiden Rastpositionen möglich, ohne dass das Lösen der ersten Rastposition die zweite Rastposition beeinflusst.

Korrespondierend zur Anordnung der beiden Rastlaschen auf zwei gegenüberliegenden Seiten des Klemmengehäuses sind auch die Rasthaken auf gegenüberliegenden Seiten am Gehäuse der Befestigungsteile angeordnet. Dabei können auch die Rasthaken in unterschiedlichen Ebenen in Aufsteckrichtung des Befestigungsteils angeordnet sein, wobei dies jedoch zur Erzielung der beiden Rastpositionen nicht unbedingt erforderlich ist, da diese auch alleine durch die Anordnung der Rastlaschen in zwei Ebenen festgelegt werden können.

Zuvor ist ausgeführt worden, dass im Klemmengehäuse der Befestigungsklemmen und am Gehäuse der Befestigungsteile mindestens eine Rastlasche bzw. mindestens ein Rasthaken für beide Rastpositionen vorgesehen ist. Eine besonders sichere und stabile Verrastung in den beiden Rastpositionen kann dadurch erreicht werden, dass im Klemmengehäuse der Befestigungsklemmen jeweils zwei Rastlaschen auf beiden Seiten des Klemmengehäuses angeordnet sind, wobei dann auch korrespondierend dazu auf beiden Seiten des Gehäuses der Befestigungsteile jeweils Rasthaken angeordnet sind. Die Rastlaschen auf einer Seite des Klemmengehäuses sind dabei vorzugsweise jeweils über einen Steg miteinander verbunden, wobei zum Lösen der beiden Rastpositionen jeweils ein Steg durch das Entriegelungselement ausgelenkt wird. Ein Auslenken eines Steges führt dann dazu, dass die angrenzenden Rastlaschen ebenfalls etwas ausgelenkt werden und dadurch nicht mehr mit den zugeordneten Rasthaken in Eingriff stehen, so dass die Rastposition bzw. die Verrastung gelöst ist und die Befestigungsteile bzw. der Prüfsteckerblock aus den Befestigungsklemmen bzw. dem Reihenklemmenblock teilweise - aus der ersten Rastposition in die zweite Rastposition - oder ganz herausgezogen werden kann.

Um das Lösen der beiden Rastpositionen zu erleichtern, ist vorzugsweise vorgesehen, dass die Entriegelungselemente jeweils auf ihren den Stegen zugewandten Seiten einen Betätigungsabschnitt aufweisen. Dabei verjüngt sich der der Entriegelung der ersten Rastposition dienende erste Betätigungsabschnitt in Aufsteckrichtung des Befestigungsteils, während sich der der Entriegelung der zweiten Rastposition dienende zweite Betätigungsabschnitt entgegen der Aufsteckrichtung des Befestigungsteils verjüngt. Die beiden Betätigungsabschnitte weisen somit jeweils eine Einführschräge auf, wobei die beiden Einführschrägen zueinander entgegengesetzt geneigt sind.

Gemäß einer weiteren besonders bevorzugten Ausgestaltung der Erfindung erfolgt die Verschiebung der Entriegelungselemente im Gehäuse der beiden Befestigungsteile durch eine Drehbewegung des Griffstücks. Hierdurch ist es möglich, dass das Entriegeln der beiden Rastpositionen und das Abziehen des Prüfsteckerblocks von dem Reihenklemmenblock mit nur einer Hand und darüber hinaus auch ohne Umgreifen erfolgen kann. Die Entriegelung mittels einer Drehbewegung des Griffstücks erfolgt dabei vorzugsweise in drei Schritten, die einfach und bequem nacheinander mit einer Hand durchgeführt werden können:
- Im ersten Schritt werden durch eine Drehung des Griffstücks um einen Winkel α in eine erste Richtung die Entriegelungselemente im Gehäuse der beiden Befestigungsteile aus einer Grundposition, in der die Befestigungsteile in der ersten Rastposition in den Befestigungsklemmen verrastet sind, in die erste Entriegelungsposition verschoben.
- Im zweiten Schritt werden durch eine weitere Drehung des Griffstücks um einen Winkel β in dieselbe Richtung die Entriegelungselemente in die dritte Position verschoben, wodurch die Befestigungsteile von den Befestigungsklemmen abgestoßen werden.
- Im dritten Schritt wird das Griffstück in die Grundposition zurückgedreht, wodurch die Entriegelungselemente in die zweite Entriegelungsposition verschoben werden.

Die Winkel α und β, um die das Griffstück in den beiden ersten Schritten gedreht wird, sind dabei so gewählt, dass das Drehen des Griffstücks vom Monteur einfach und bequem mit einer Hand erfolgen kann. Daher ist es vorteilhaft, wenn das Griffstück in beiden Schritten nicht zu weiter verdreht werden muss, vorzugsweise zusammen weniger als 180°, insbesondere weniger als 120°, beispielsweise ca. 90°. Die Winkel α und β können dabei im Wesentlichen gleich sein, beispielsweise jeweils ca. 45° betragen. Ebenso ist es jedoch auch möglich, dass die beiden Winkel α und β unterschiedlich groß sind, beispielsweise der Winkel α ca. 20° - 40° und der Winkel β ca. 50° - 70° beträgt.

Ein derartiges zweistufiges Verdrehen des Griffstücks um weniger als 120° ist sehr einfach und bequem mit einer Hand durchführbar, ohne dass ein Umgreifen erforderlich ist. Dadurch, dass zum Verschieben der Entriegelungselemente in die zweite Entriegelungsposition und damit zum Lösen der zweiten Rastposition das Griffstück wieder zurückgedreht werden muss, wird außerdem sichergestellt, dass der Prüfsteckerblock nicht aus Versehen durch ein zu weites Verdrehen des Griffstücks und ein einmaliges starkes Ziehen am Griffstück vollständig aus dem Reihenklemmenblock herausgezogen wird.

Um die Drehbewegung des Griffstücks in eine geradlinige Bewegung der Entriegelungselemente umzuwandeln, ist vorzugsweise im Gehäuse der beiden Befestigungsteile jeweils eine Getriebeanordnung angeordnet, über die die beiden Entriegelungselemente jeweils mit dem Griffstück verbunden sind. Vorzugsweise weisen die Getriebeanordnungen dabei jeweils zwei Zahnräder und eine Pleuelstange auf, die an ihrem einen Ende mit einem Zahnrad und an ihrem anderen Ende mit einem Entriegelungselement verbunden ist. Durch eine geeignete Wahl der beiden Zahnräder, von denen eines mit einem Ende des Griffstücks verbunden ist, kann dabei eine vorteilhafte Kraftübersetzung erreicht werden. Dies ist insbesondere mit Blick auf die zusätzliche Funktion der Entriegelungselemente als Auswurfs- bzw. Abzugshilfe beim Herausziehen des Prüfsteckerblocks aus dem Reihenklemmenblock vorteilhaft. Hierdurch kann die Kraft, die aufgebracht werden muss, um die Entriegelungselemente in die dritte Position zu verschieben, in der das Gehäuse der Befestigungsteile vom Klemmengehäuse der Befestigungsklemmen abgestoßen wird und damit die kürzeren Prüfstecker aus den federnden Kontaktbereichen herausgezogen werden, relativ gering bleiben, auch bei einem Prüfklemmenblock mit einer Mehrzahl von Reihenklemmen und einer Mehrzahl von Prüfsteckern.

Eingangs ist ausgeführt worden, dass der Prüfsteckerblock eine Mehrzahl von miteinander verbundenen Prüfsteckern und auf beiden Seiten der Mehrzahl von Prüfsteckern je ein Befestigungsteil aufweist. Die mechanische Verbindung der einzelnen Prüfstecker untereinander erfolgt dabei vorzugsweise dadurch, dass die Gehäuse der Prüfstecker auf den einander zugewandten Seiten zueinander korrespondierende Rastausnehmungen und Rastzapfen aufweisen. Dabei sind vorzugsweise auf einer Seite der Gehäuse Rastzapfen und auf der gegenüberliegenden Seite - zu den Rastzapfen des angrenzenden Prüfsteckers - korrespondierende Rastausnehmungen vorgesehen. Entsprechend sind auch die beiden Befestigungsteile mittels an den Gehäusen der Befestigungsteile ausgebildeter bzw. angeordneter Rastzapfen oder Rastausnehmungen mit den Prüfsteckern mechanisch verbunden.
Eine zusätzliche mechanische Verbindung bzw. Fixierung des Prüfsteckerblocks erfolgt über das Griffstück, das mit den beiden Befestigungsteilen verbunden, beispielsweise verschraubt wird. Darüber hinaus kann alternativ oder vorzugsweise zusätzlich eine mechanische Verbindung des Prüfsteckerblocks auch über eine Gewindestange gewährleistet werden, die durch die beiden Befestigungsteile und alle Prüfstecker durchgesteckt und an einer Außenseite eines Befestigungsteils mit einer Mutter verschraubt wird. Hierdurch ist sichergestellt, dass der Prüfsteckerblock eine sehr stabile Einheit bildet, die einfach auf den Reihenklemmenblock aufgesteckt bzw. vom Reihenklemmenblock abgezogen werden kann.
Auch die Befestigungsklemmen sind vorzugsweise mechanisch mit den Reihenklemmen verbunden, wobei an den Befestigungsklemmen ebenfalls Rastzapfen und/oder Rastausnehmungen angeordnet und in der Seitenwand der Klemmengehäuse der Reihenklemmen korrespondierend ausgebildete Rastausnehmungen oder Rastzapfen vorgesehen sind. Da die Reihenklemmen häufig auf einer Tragschiene aufgerastet sind, ist eine Verrastung der Reihenklemmen untereinander oder auch mit den Befestigungsklemmen jedoch nicht unbedingt notwendig. Außerdem können an Stelle der Rastzapfen und der Rastausnehmungen auch andere Rastelemente an den Befestigungsklemmen und den Reihenklemmen bzw. an den Befestigungsteilen und den Prüfsteckern ausgebildet sein.
Die erfindungsgemäß vorgesehene zweistufige Verrastung ist insbesondere dann besonders vorteilhaft, wenn die Kontaktstecker der einzelnen Prüfstecker unterschiedliche Längen aufweisen, wobei die einzelnen Kontaktstecker der Prüfstecker insbesondere zwei unterschiedliche Längen haben, auch wenn die vorliegende Erfindung nicht darauf beschränkt ist.

Neben dem zuvor beschriebenen Prüfklemmenblock betrifft die Erfindung auch eine Baugruppe aus einer Befestigungsklemme und einem mit einem Prüfsteckerblock verbindbaren Befestigungsteil zur Verwendung bei einem entsprechenden Prüfklemmenblock nach Anspruch 1. Die eingangs genannte Aufgabe ist bei einer derartigen Baugruppe dadurch gelöst, dass das Klemmengehäuse der Befestigungsklemme mindestens zwei Rastelemente und das Gehäuse des Befestigungsteils mindestens zwei korrespondierende Gegenrastelemente aufweist, wobei die Rastelemente und die Gegenrastelemente zusammen zwei in Aufsteckrichtung des Befestigungsteils hintereinander angeordnete Rastpositionen des Befestigungsteils in der Befestigungsklemme festlegen. Wie zuvor bereits im Zusammenhang mit dem erfindungsgemäßen Prüfklemmenblock ausgeführt worden ist, ist außerdem im Gehäuse des Befestigungsteils ein Entriegelungselement verschiebbar angeordnet, das in eine erste Entriegelungsposition und in eine zweite Entriegelungsposition verbringbar ist, wobei in der ersten Entriegelungsposition die Verriegelung der ersten Rastposition und in der zweiten Entriegelungsposition die Verriegelung der zweiten Rastposition durch das Entriegelungselement gelöst ist.

Bezüglich der Vorteile der Anordnung und Ausbildung der Rastelemente sowie der Gegenrastelemente und des Entriegelungselements im Gehäuse des Befestigungsteils wird auf die vorstehenden Ausführungen im Zusammenhang mit dem erfindungsgemäßen Prüfklemmenblock verwiesen. Auch bei der Baugruppe sind die Rastelemente vorzugsweise als Rastlaschen und die Gegenrastelemente als Rasthaken ausgebildet, wobei die vorzugsweise zwei Rastlaschen der ersten Rastposition und die vorzugsweise zwei Rastlaschen der zweiten Rastposition auf gegenüberliegenden Seiten des Klemmengehäuses und in unterschiedlichen Ebenen in Aufsteckrichtung des Befestigungsteils angeordnet sind.

Weitere vorteilhafte Ausgestaltungen der erfindungsgemäßen Baugruppe, wie beispielsweise die Anordnung einer Getriebeanordnung im Gehäuse des Befestigungsteils, ergeben sich aus den Patentansprüchen 2 und 3. Im Einzelnen gibt es nun eine Vielzahl von Möglichkeiten, den erfindungsgemäßen Prüfklemmenblock bzw. die erfindungsgemäße Baugruppe auszugestalten und weiterzubilden. Dazu wird verwiesen sowohl auf die den Patentansprüchen 1 und 13 nachgeordneten Patentansprüche als auch auf die nachfolgende Beschreibung eines bevorzugten Ausführungsbeispiels in Verbindung mit der Zeichnung. In der Zeichnung zeigen
- Fig. 1: einen erfindungsgemäßen Prüfklemmenblock im vollständig eingesteckten Zustand, in perspektivischer Darstellung,
- Fig. 2: eine Befestigungsklemme des Prüfklemmenblocks gemäß Fig. 1,
- Fig. 3: ein Befestigungsteil des Prüfklemmenblocks, in Seitenansicht,
- Fig. 4: eine Befestigungsklemme mit einem vollständig eingesteckten Befestigungsteil, von der Seite,
- Fig. 5: die Baugruppe aus Befestigungsklemme und Befestigungsteil gemäß Fig. 4, in der ersten Rastposition, von der Innenseite,
- Fig. 6: einen Ausschnitt der Baugruppe gemäß Fig. 5, von der Außenseite,
- Fig. 7: die Baugruppe gemäß Fig. 4 in der zweiten Rastposition, von der Innenseite,
- Fig. 8: einen Ausschnitt der Baugruppe gemäß Fig. 7, von der Außenseite,
- Fig. 9: die Baugruppe gemäß Fig. 4, mit entriegelter zweiter Raststufe, von der Innenseite,
- Fig. 10: einen Ausschnitt der Baugruppe gemäß Fig. 9, von der Außenseite,
- Fig. 11: zwei perspektivische Darstellungen des Entriegelungselements, um 180° zueinander gedreht,
- Fig. 12: eine separate Darstellung der im Gehäuse der Befestigungsteile gemäß Fig. 4 angeordneten Getriebeanordnung mit Entriegelungselement, und
- Fig. 13: zwei Darstellungen eines Prüfsteckers, eingesteckt in eine Trennstelle einer Reihenklemme, in zwei Einsteckpositionen.

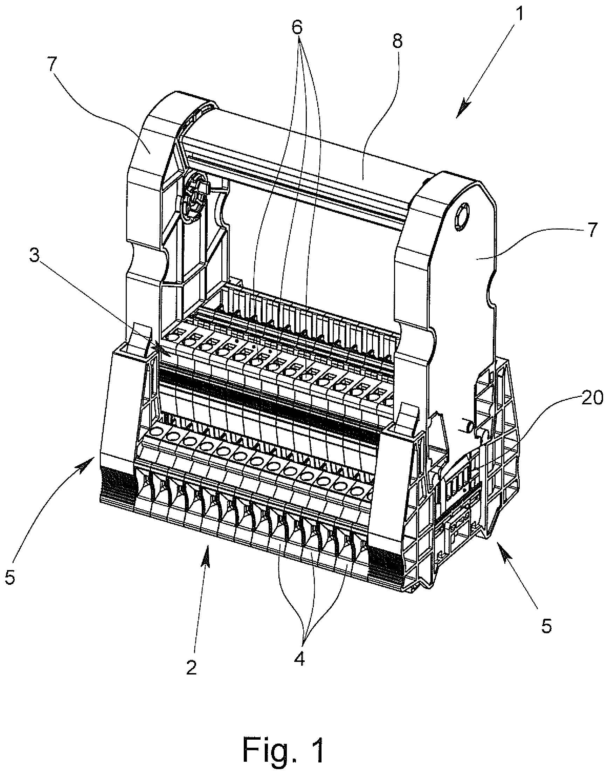

Der insgesamt nur in Fig. 1 dargestellte Prüfklemmenblock 1 besteht aus einem Reihenklemmenblock 2 und einem Prüfsteckerblock 3, der auf den Reihenklemmenblock 2 aufsteckbar ist. Der Reihenklemmenblock 2 besteht aus einer Mehrzahl von nebeneinander angeordneten Reihenklemmen 4 und zwei Befestigungsklemmen 5, die an den beiden Seiten der Mehrzahl von Reihenklemmen 4 angeordnet sind. Entsprechend besteht der Prüfsteckerblock 3 aus einer Mehrzahl von miteinander verbundenen Prüfsteckern 6 und zwei Befestigungsteilen 7, die auf beiden Seiten der Mehrzahl von Prüfsteckern 6 angeordnet sind. Darüber hinaus weist der Prüfsteckerblock 3 noch ein Griffstück 8 auf, über das die beiden Befestigungsteile 7 miteinander verbunden sind, wobei die Höhe der beiden Befestigungsteile 7 wesentlich größer als die Höhe der Prüfstecker 6 ist, so dass das Griffstück 8, das am oberen Ende der Befestigungsteile 7 angeordnet ist, bequem von einer Hand eines Monteurs umgriffen werden kann.

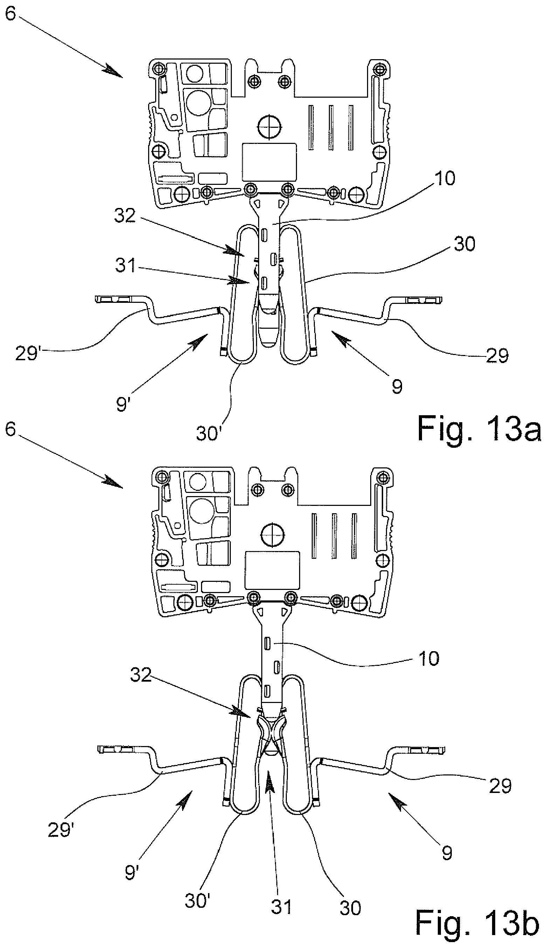

Die einzelnen Reihenklemmen 4 weisen jeweils zwei Strombalken 9, 9' auf, die zusammen eine Trennstelle bilden, in die ein Kontaktstecker 10 eines Prüfsteckers 6 eingesteckt werden kann (vgl. Fig. 13). Darüber hinaus weisen die einzelnen Reihenklemmen 4 noch jeweils zwei Leiteranschlusselemente auf, denen jeweils ein erster Endbereich eines Strombalkens 9, 9' zugeordnet ist. Bei nicht eingestecktem Kontaktstecker 10 kontaktieren die beiden Strombalken 9, 9' einander in der Trennstelle, so dass die Leiteranschlusselemente elektrisch leitend miteinander verbunden sind. Ist dagegen ein Kontaktstecker 10 vollständig in die Reihenklemme 4 bzw. die Trennstelle eingesteckt, so ist der Kontaktbereich aufgetrennt, so dass die Leiteranschlusselemente elektrisch voneinander getrennt sind. Da bei der vorliegenden Erfindung der konkrete Aufbau der einzelnen Reihenklemmen 4 nicht im Vordergrund steht, sind diese in den Figuren nicht weiter im Detail dargestellt.

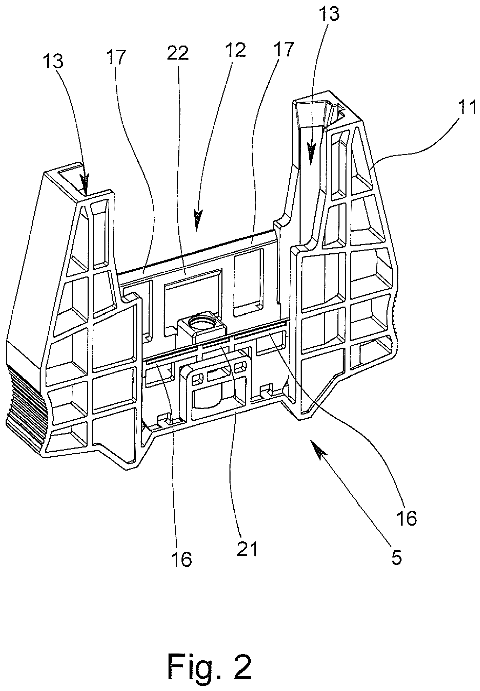

Wie insbesondere aus den Fig. 2 bis 4 ersichtlich ist, weisen die Befestigungsklemmen 5 jeweils ein Klemmengehäuse 11 mit einem nach oben offenen Aufnahmeabschnitt 12 auf, der seitlich von zwei Führungsnuten 13 begrenzt wird. Korrespondierend dazu weist das Gehäuse 14 der Befestigungsteile 7 einen zum Aufnahmeabschnitt 12 korrespondierenden Einsteckabschnitt auf, der von zwei Führungsstegen 15 gebildet wird, die senkrecht in die Führungsnuten 13 eingesteckt werden können.

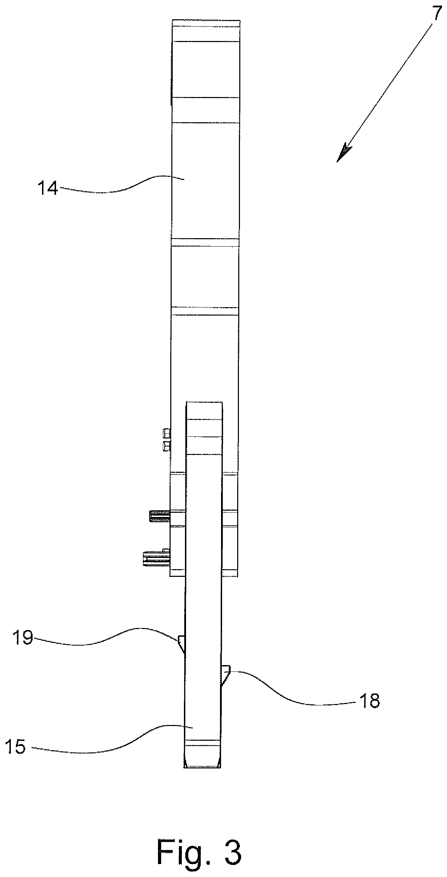

Aus den Fig. 2 und 3 ist darüber hinaus ersichtlich, dass im Klemmengehäuse 11 der Befestigungsklemme 5 mehrere als Rastlaschen 16, 17 ausgebildete Rastelemente und am Gehäuse 14 des Befestigungsteils 7 eine entsprechende Anzahl an korrespondierenden Gegenrastelementen angeordnet sind, die als Rasthaken 18, 19 ausgebildet sind. Die Rastlaschen 16, 17 und die zugeordneten Rasthaken 18, 19 legen dabei zusammen zwei in Aufsteckrichtung der Befestigungsteile 7 bzw. des Prüfsteckerblocks 3 hintereinander angeordnete Rastpositionen der Befestigungsteile 7 in den Befestigungsklemmen 5 fest. In der Ausrichtung des Prüfklemmenblocks 1 gemäß den Figuren sind die Befestigungsteile 7 - und mit ihnen auch der Prüfsteckerblock 3 - somit in einer ersten, unteren Rastposition und einer zweiten, oberen Rastposition in den Befestigungsklemmen 5 bzw. am Reihenklemmenblock 2 verrastbar.

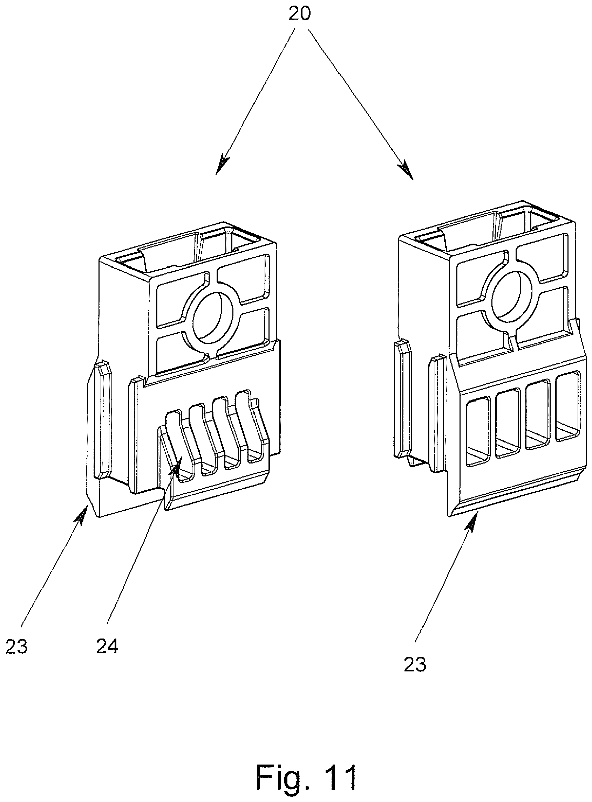

Die auf der Außenseite der Befestigungsklemme 5, d. h. auf der den Reihenklemmen 4 abgewandten Seite des Klemmengehäuses 11, ausgebildeten beiden Rastlaschen 16 legen dabei zusammen mit den auf der Außenseite des Befestigungsteils 7, d. h. auf der den Prüfsteckern 6 abgewandten Seite des Gehäuses 14, angeordneten beiden Rasthaken 18 die erste Rastposition fest. Entsprechend wird die zweite Rastposition durch die beiden auf der Innenseite des Klemmengehäuses 11 ausgebildeten Rastlaschen 17 und die an der Innenseite des Gehäuses 14 angeordneten Rasthaken 19 festgelegt. Zum Lösen der Verriegelung der beiden Rastpositionen ist im Gehäuse 14 des Befestigungsteils 7 ein Entriegelungselement 20 verschiebbar angeordnet, das separat in Fig. 11 von zwei gegenüberliegenden Seiten perspektivisch dargestellt ist.

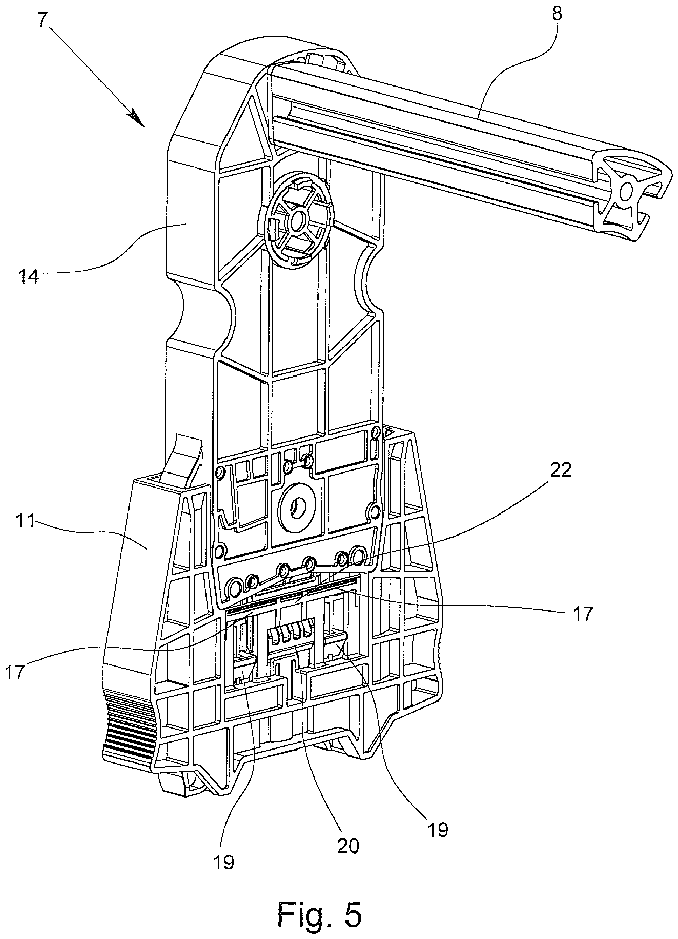

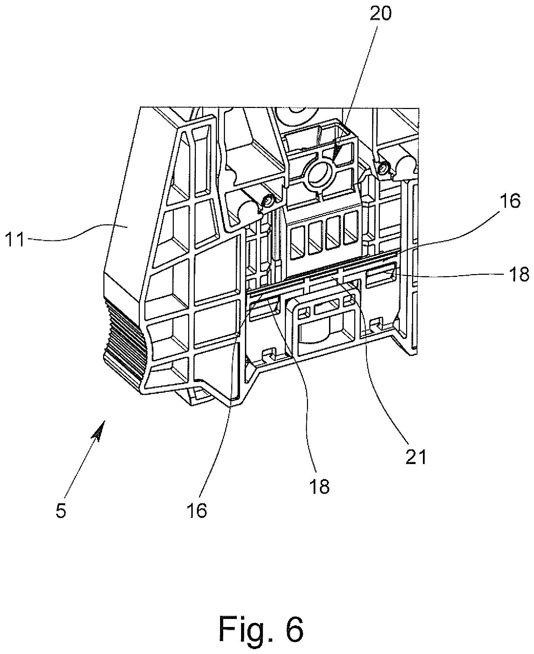

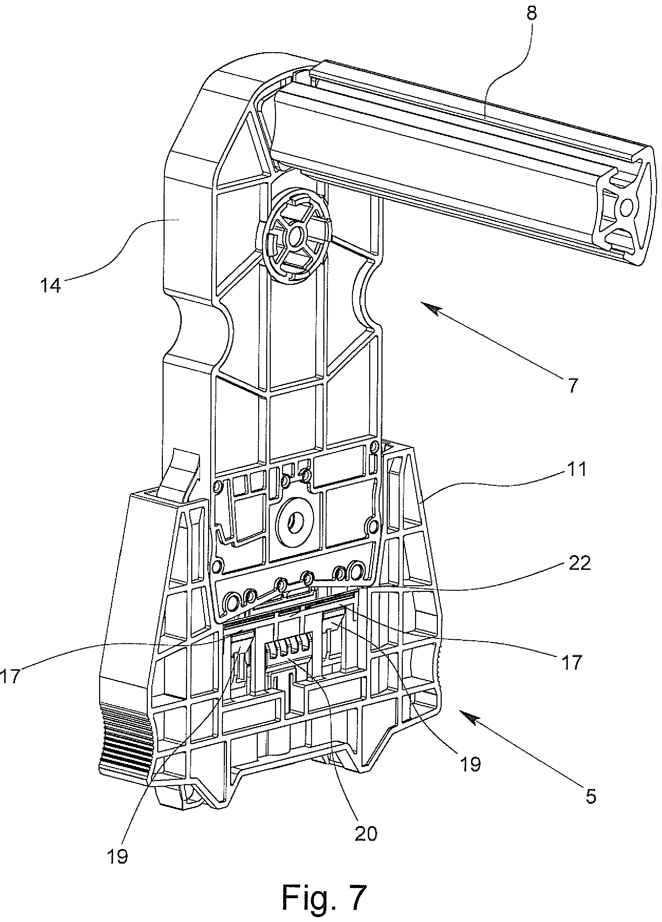

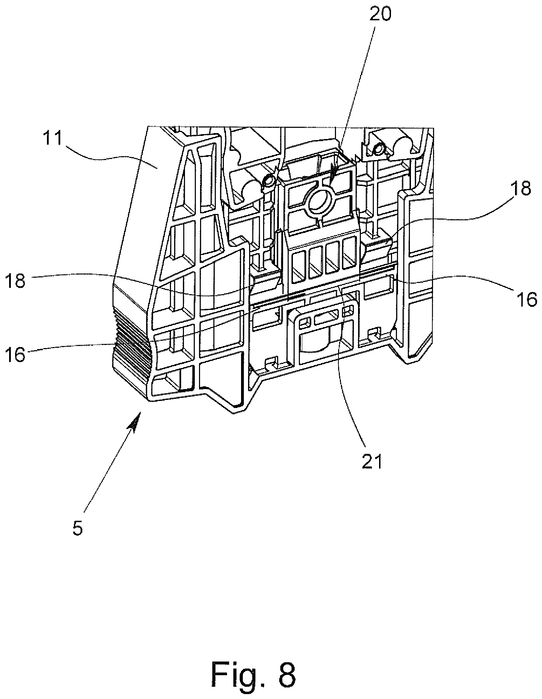

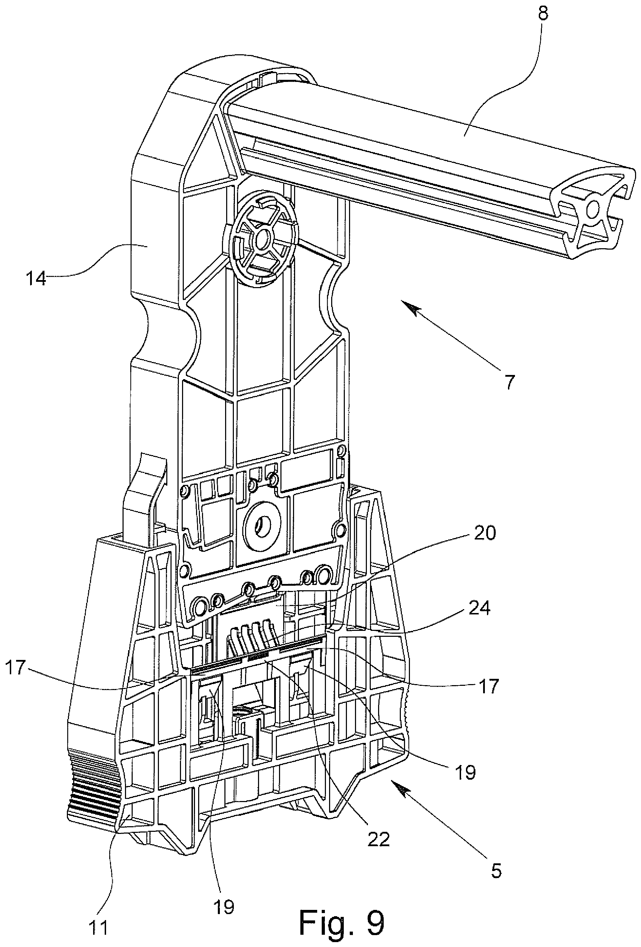

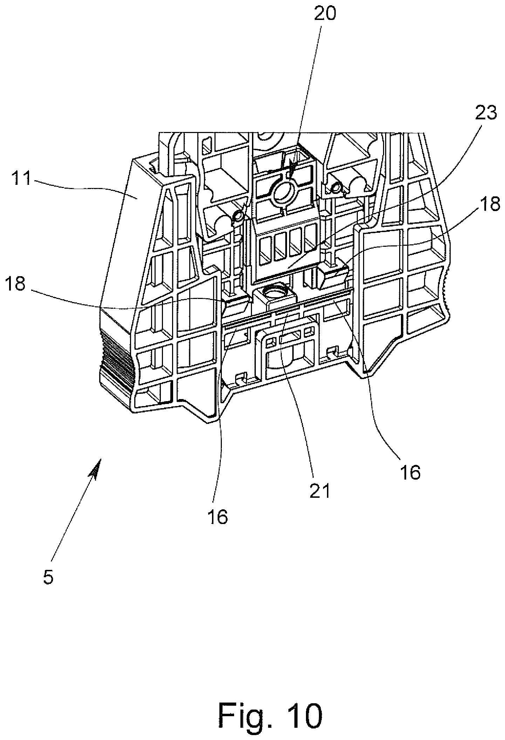

Die einzelnen Schritte zum Entriegeln bzw. Lösen der beiden Rastpositionen beim Abziehen des Prüfsteckerblocks 3 vom Reihenklemmenblock 2 werden nachfolgend anhand der Fig. 5 bis 10 beschrieben, wobei die Fig. 5, 7 und 9 die Innenseite der Baugruppe aus Befestigungsklemme 5 und Befestigungsteil 7 und die Fig. 6, 8 und 10 einen Ausschnitt der Außenseite der Baugruppe darstellen. Die Fig. 5 und 6 zeigen dabei den Zustand der Baugruppe, wenn die erste Rastposition gelöst ist, die Fig. 7 und 8 den Zustand der Baugruppe in der zweiten Rastposition und die Fig. 9 und 10 den Zustand der Baugruppe bei gelöster zweiter Rastposition.

Aus einem Vergleich der Fig. 5, 7 und 9 ist darüber hinaus ersichtlich, dass eine Veränderung der Position des Entriegelungselements 20 durch eine Drehbewegung des Griffstücks 8 erreicht wird. Im Grundzustand des Prüfsteckerblocks, der in Fig. 1 dargestellt ist, ist der Prüfsteckerblock 3 vollständig auf dem Reihenklemmenblock 2 aufgesteckt und die im Klemmengehäuse 11 der Befestigungsklemmen 5 ausgebildeten Rastlaschen 16 sind mit den am Gehäuse 14 der Befestigungsteile 7 angeordneten Rasthaken 18 in der ersten Rastposition verrastet. Im Vergleich zum Grundzustand gemäß Fig. 1 ist bei dem in Fig. 5 dargestellten Zustand das Griffstück 8 um einen Winkel α von ca. 30° gedreht worden. In der Situation gemäß Fig. 7 ist das Griffstück um weitere 60°, also insgesamt um 90° gedreht, verglichen mit dem Grundzustand gemäß Fig. 1. In der Position gemäß Fig. 9 ist schließlich das Griffstück 8 wieder um 90° zurückgedreht worden.

Wie in Fig. 6 dargestellt ist, führt das Verdrehen des Griffstücks 8 in die erste Position gemäß Fig. 5 dazu, dass das Entriegelungselement 20 senkrecht nach unten bewegt wird, wodurch die Verriegelung zwischen den Rastlaschen 16 und Rasthaken 18 gelöst wird. Hierzu sind die Rastlaschen 16 - ebenso wie die auf der anderen Seite angeordneten Rastlaschen 17 - über einen Steg 21 miteinander verbunden, der durch das Entriegelungselement 20 ausgelenkt wird. Das Entriegelungselement 20 weist dazu gemäß Fig. 11 auf den beiden den Stegen 21, 22 zugewandten Seite jeweils einen Betätigungsabschnitt 23, 24 auf. Aus Fig. 11 ist dabei auch ersichtlich, dass sich der der Entriegelung der ersten Rastposition dienende erste Betätigungsabschitt 23 in Aufsteckrichtung des Befestigungsteils 7 verjüngt, während sich der der Entriegelung der zweiten Rastposition dienende zweite Betätigungsabschnitt 24 entgegen der Aufsteckrichtung des Befestigungsteils 7 verjüngt. Dies führt dazu, dass der Betätigungsabschnitt 23 den Steg 21 einfacher auslenken kann, wenn das Entriegelungselement 20 durch Verdrehen des Griffstücks 8 in Uhrzeigerrichtung nach unten verschoben wird.

Da die Unterkante des Entriegelungselements 20 in der ersten Entriegelungsposition bereits auf der Oberseite des Klemmengehäuses 11 der Befestigungsklemme 5 aufsitzt, führt ein weiteres Verdrehen des Griffstücks 8 in Uhrzeigerrichtung gemäß Fig. 7 dazu, dass das Entriegelungselement 20 nicht mehr weiter nach unten verschoben werden kann. Da jedoch das Entriegelungselement 20 relativ zum Gehäuse 14 des Befestigungsteils 7 verschiebbar ist, wird das Gehäuse 14 des Befestigungsteils 7 von dem Klemmengehäuse 11 der Befestigungsklemme 5 abgestoßen, d. h. das Gehäuse 14 wird nach oben geschoben, wenn das Entriegelungselement 20 durch die weitere Drehbewegung des Griffstücks 8 relativ zum Gehäuse 14 des Befestigungsteils 7 in eine dritte Position verschoben wird. Die Bewegung des Gehäuses 14 des Befestigungsteils 7 weg vom Klemmengehäuse 11 der Befestigungsklemme 5 wird dabei dadurch begrenzt, dass die Rasthaken 19 mit den zugeordneten Rastlaschen 17 in Eingriff kommen, wie dies in Fig. 7 dargestellt ist. Das Befestigungsteil 7 befindet sich dann in der zweiten Rastposition in der Befestigungsklemme 5.

Um die zweite Rastposition zu lösen bzw. zu entriegeln, wird das Griffstück 8 gemäß Fig. 9 wieder um 90° zurückgedreht. Dadurch wird das Entriegelungselement 20 im Gehäuse 14 des Befestigungsteils 7 wieder noch oben verschoben, wobei der Betätigungsabschnitt 24 des Entriegelungselements 20 den Steg 22 zwischen den beiden Rastlaschen 17 auslenkt, so dass die Verriegelung zwischen den Rastlaschen 17 und den zugeordneten Rasthaken 19 gelöst wird. Der Prüfsteckerblock 3 kann nun ganz vom Reihenklemmenblock 2 abgezogen werden.

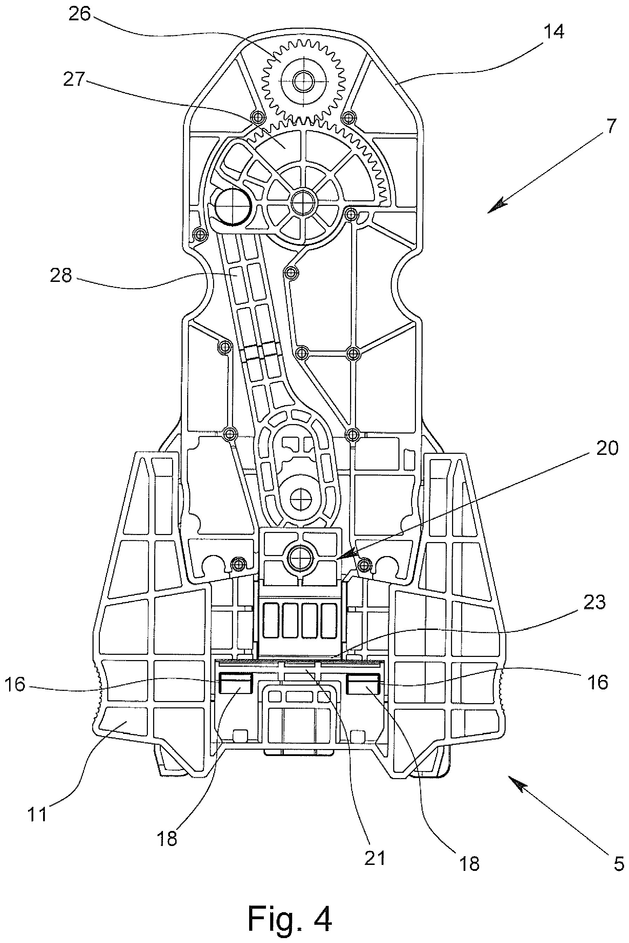

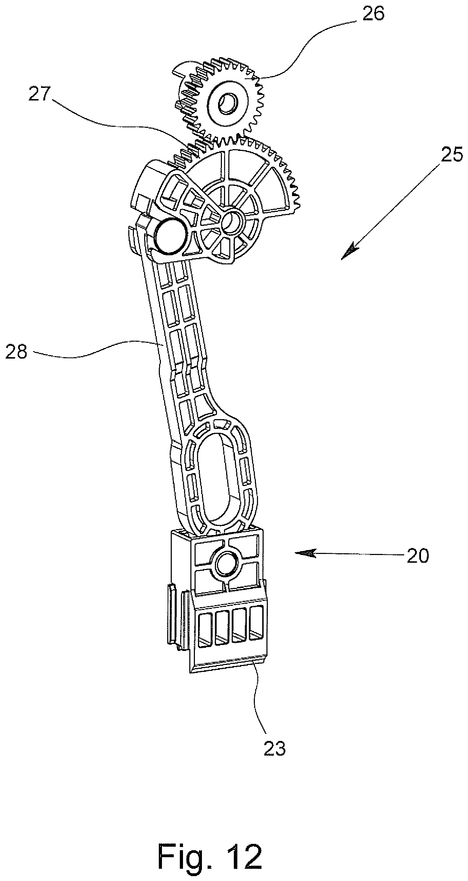

Um die Drehbewegung des Griffstücks 8 in eine senkrechte Bewegung des Entriegelungselements 20 umzuwandeln, ist im Gehäuse 14 des Befestigungsteils 7 eine Getriebeanordnung 25 angeordnet (Fig. 4). Die Getriebeanordnung 25 weist dabei gemäß Fig. 12 zwei Zahnräder 26, 27 und eine Pleuelstange 28 auf, die an ihrem einen Ende mit einem Zahnrad 27 und an ihrem anderen Ende mit dem Entriegelungselement 20 verbunden ist. Dadurch, dass das zweite Zahnrad 27 einen größeren Durchmesser als das erste Zahnrad 26 hat, das mit dem Griffstück 8 verbunden ist, wird eine vorteilhafte Kraftübersetzung erreicht. Dadurch muss die manuell vom Monteur beim Herausziehen des Prüfsteckerblocks 3 aus dem Reihenklemmenblock 2 aufzubringende Kraft nur relativ gering sein, auch wenn der Prüfklemmenblock 1 eine Mehrzahl von Reihenklemmen 4 und eine Mehrzahl von Prüfsteckern 6 aufweist.

Die Figuren 13a und 13b zeigen einen Prüfstecker 6 mit seinem Kontaktstecker 10 eingesteckt in die Trennstelle einer Reihenklemme 4, in zwei unterschiedlichen Positionen, wobei von der Reihenklemme nur die beiden Strombalken 9, 9' dargestellt sind. Die beiden Strombalken 9, 9' bestehen bei dem dargestellten Ausführungsbeispiel jeweils aus zwei länglichen Metallstreifen, die im Übergangsbereich miteinander verlötet oder verschweißt sind und aus unterschiedlichen Materialien bestehen können. Die einen Metallstreifen bilden dabei die einen Endbereiche 29, 29', die den Leiteranschlusselementen der Reihenklemmen zugeordnet sind, während die anderen Metallstreifen die zweiten Endbereiche 30, 30' der Strombalken 9, 9' bilden. Die zweiten Endbereiche 30, 30' sind so abgebogen, dass sie zusammen einen ersten Kontaktbereich 31 und einen zweiten Kontaktbereich 32 für den Kontaktstecker 10 eines Prüfsteckers 6 bilden.

Im vollständig eingesteckten Zustand des Kontaktsteckers 10 gemäß Fig. 13a sind die beiden zweiten Endbereiche 30, 30' durch den Kontaktstecker 10 voneinander getrennt, so dass beide Kontaktbereiche 31, 32 aufgetrennt sind und die elektrisch leitende Verbindung über die Strombalken 9, 9' unterbrochen ist. Ist der Prüfstecker 10 dagegen gemäß Fig. 13b etwas aus der Reihenklemme 4 herausgezogen, so kontaktiert der Kontaktstecker 10 die zweiten Endbereiche 30, 30' nur noch im zweiten, oberen Kontaktbereich 32. Da der Kontaktstecker 10 nicht mehr im ersten, unteren Kontaktbereich 31 eingesteckt ist, kontaktieren sich hier die beiden zweiten Endbereiche 30, 30' der beiden Strombalken 9, 9', so dass die Leiteranschlusselemente über die Strombalken 9, 9' elektrisch leitend miteinander verbunden sind.

## Patentansprüche

1. Baugruppe aus einer Befestigungsklemme (5) und einem mit einem Prüfsteckerblock (3) verbindbaren Befestigungsteil (7),
**dadurch gekennzeichnet, dass** das Klemmengehäuse (11) der Befestigungsklemme (5) mindestens zwei Rastelemente (16, 17) und das Gehäuse (14) des Befestigungsteils (7) mindestens zwei korrespondierende Gegenrastelemente (18, 19) aufweist, wobei die Rastelemente (16, 17) und die Gegenrastelemente (18, 19) zusammen zwei in Aufsteckrichtung des Befestigungsteils (7) hintereinander angeordnete Rastpositionen des Befestigungsteils (7) in der Befestigungsklemme (5) festlegen, und dass im Gehäuse (14) des Befestigungsteils (7) ein Entriegelungselement (20) verschiebbar angeordnet ist, das in eine erste Entriegelungsposition und in eine zweite Entriegelungsposition verbringbar ist, wobei in der ersten Entriegelungsposition die Verriegelung der ersten Rastposition und in der zweiten Entriegelungsposition die Verriegelung der zweiten Rastposition durch das Entriegelungselement (20) gelöst ist.

2. Baugruppe nach Anspruch 1, **dadurch gekennzeichnet, dass** als Rastelemente Rastlaschen (16, 17) im Klemmgehäuse (11) der Befestigungsklemme (5) und als Gegenrastelemente Rasthaken (18, 19) am Gehäuse (14) des Befestigungsteils (7) ausgebildete sind, wobei die mindestens eine Rastlasche (16) der ersten Rastposition und die mindestens eine Rastlasche (17) der zweiten Rastposition auf gegenüberliegenden Seiten des Klemmgehäuses (11) und in unterschiedlichen Ebenen in Aufsteckrichtung des Befestigungsteils (7) angeordnet sind.

3. Baugruppe nach Anspruch 1 oder 2, **dadurch gekennzeichnet, dass** im Klemmengehäuse (11) der Befestigungsklemme (5) zwei Rastlaschen (16, 17) auf beiden Seiten des Klemmengehäuses (11) angeordnet sind, die jeweils über einen Steg (21, 22) miteinander verbunden sind, wobei zum Lösen der beiden Rastpositionen jeweils ein Steg (21, 22) durch das Entriegelungselement (20) ausgelenkt wird.

4. Prüfklemmenblock bestehend aus einem Reihenklemmenblock (2) und einem auf den Reihenklemmenblock (2) aufsteckbaren Prüfsteckerblock (3),
wobei der Reihenklemmenblock (2) eine Mehrzahl von nebeneinander angeordneten Reihenklemmen (4) und auf beiden Seiten der Mehrzahl von Reihenklemmen (4) je eine Befestigungsklemme (5) aufweist,
wobei der Prüfsteckerblock (3) eine Mehrzahl von miteinander verbundenen Prüfsteckern (6) und auf beiden Seiten der Mehrzahl von Prüfsteckern (6) je ein Befestigungsteil (7) aufweist, wobei die beiden Befestigungsteile (7) über ein Griffstück (8) miteinander verbunden sind,
wobei jede Reihenklemme (4) zwei Strombalken (9) aufweist, die zusammen eine Trennstelle bilden und wobei jeder Prüfstecker (6) einen in eine Trennstelle einsteckbaren Kontaktstecker (10) aufweist, und
wobei die beiden Befestigungsklemmen (5) jeweils ein Klemmengehäuse (11) mit einem Aufnahmeabschnitt (12) und die beiden Befestigungsteile (7) jeweils ein Gehäuse (14) mit einem korrespondierenden, in den Aufnahmeabschnitt (12) einsteckbaren Einsteckabschnitt (15) aufweisen,
**dadurch gekennzeichnet,**
**dass** jeweils eine Befestigungsklemme (5) und ein Befestigungsteil (7) eine Baugruppe nach Anspruch 1 bilden.

5. Prüfklemmenblock nach Anspruch 4, **dadurch gekennzeichnet, dass** die Unterkante des Entriegelungselements (20) in der ersten Entriegelungsposition auf der Oberseite des Klemmengehäuses (11) der Befestigungsklemme (5) aufsitzt und dass das Entriegelungselement (20) aus der ersten Entriegelungsposition in Aufsteckrichtung der Befestigungsteile (7) weiter in eine dritte Position verschiebbar ist, wodurch das Gehäuse (14) des Befestigungsteils (7) von dem Klemmengehäuse (11) der Befestigungsklemme (5) abgestoßen wird.

6. Prüfklemmenblock nach Anspruch 4 oder 5, **dadurch gekennzeichnet, dass** als Rastelemente Rastlaschen (16, 17) im Klemmengehäuse (11) der Befestigungsklemmen (5) und als Gegenrastelemente Rasthaken (18, 19) am Gehäuse (14) der Befestigungsteile (7) ausgebildet sind, wobei die mindestens eine Rastlasche (16) der ersten Rastposition und die mindestens eine Rastlasche (17) der zweiten Rastposition auf gegenüberliegenden Seiten des Klemmengehäuses (11) und in unterschiedlichen Ebenen in Aufsteckrichtung der Befestigungsteile (7) angeordnet sind.

7. Prüfklemmenblock nach Anspruch 6, **dadurch gekennzeichnet, dass** im Klemmengehäuse (11) der Befestigungsklemmen (5) jeweils zwei Rastlaschen (16, 17) auf beiden Seiten des Klemmengehäuses (11) angeordnet sind, die jeweils über einen Steg (21, 22) miteinander verbunden sind, wobei zum Lösen der beiden Rastpositionen jeweils ein Steg (21, 22) durch das Entriegelungselement (20) ausgelenkt wird.

8. Prüfklemmenblock nach Anspruch 7, **dadurch gekennzeichnet, dass** die Entriegelungselemente (20) jeweils auf ihren den Stegen (21, 22) zugewandten Seiten einen Betätigungsabschnitt (23, 24) aufweisen, wobei sich der der Entriegelung der ersten Rastposition dienende erste Betätigungsabschnitt (23) in Aufsteckrichtung der Befestigungsteile (7) verjüngt während sich der der Entriegelung der zweiten Rastposition dienende zweite Betätigungsabschnitt (24) entgegen der Aufsteckrichtung der Befestigungsteile (7) verjüngt.

9. Prüfklemmenblock nach einem der Ansprüche 4 bis 8, **dadurch gekennzeichnet, dass** die Verschiebung der Entriegelungselemente (20) im Gehäuse (14) der beiden Befestigungsteile (7) durch eine Drehbewegung des Griffstücks (8) erfolgt.

10. Prüfklemmenblock nach Anspruch 9, **dadurch gekennzeichnet, dass** im Gehäuse (14) der beiden Befestigungsteile (7) jeweils eine Getriebeanordnung (25) angeordnet ist, über die die beiden Entriegelungselemente (20) jeweils mit dem Griffstück (8) verbunden sind, wobei die Getriebeanordnungen (25) vorzugsweise jeweils zwei Zahnräder (26, 27) und eine Pleuelstange (28), die an einem Ende mit einem Zahnrad (27) und am anderen Ende dem mit Entriegelungselement (20) verbunden ist, aufweist.

11. Prüfklemmenblock nach Anspruch 9 oder 10, **dadurch gekennzeichnet, dass** durch eine Drehung des Griffstücks (8) um einen Winkel α in eine erste Richtung die Entriegelungselemente (20) im Gehäuse (14) der beiden Befestigungsteile (7) aus einer Grundposition in die erste Entriegelungsposition, durch eine weitere Drehung des Griffstücks (8) um einen Winkel β in dieselbe Richtung die Entriegelungselemente (20) in die dritte Position und durch Zurückdrehen des Griffstücks (8) in die Grundposition die Entriegelungselemente (20) in die zweite Entriegelungsposition verschiebbar sind.

12. Prüfklemmenblock nach einem der Ansprüche 4 bis 11, **dadurch gekennzeichnet, dass** die beiden Befestigungsteile (7) mittels am Gehäuse (14) der Befestigungsteile (7) angeordneter Rastzapfen und/oder Rastausnehmungen und in der Seitenwand der Gehäuse der Prüfstecker (6) ausgebildeter Rastausnehmungen und/oder Rastzapfen mechanisch mit den Prüfsteckern (6) verbindbar sind.

13. Prüfklemmenblock nach einem der Ansprüche 4 bis 12, **dadurch gekennzeichnet, dass** die beiden Befestigungsklemme (5) mechanisch mit den Reihenklemmen (4) verbindbar sind, insbesondere mittels an den Befestigungsklemmen (5) angeordneter Rastzapfen und/oder Rastausnehmungen und in der Seitenwand der Klemmengehäuse der Reihenklemmen (4) ausgebildeter Rastausnehmungen und/oder Rastzapfen.

14. Prüfklemmenblock nach einem der Ansprüche 4 bis 13, **dadurch gekennzeichnet, dass** die Reihenklemmen (4) jeweils mindestens zwei Leiteranschlusselemente und mindestens zwei Strombalken (9, 9') aufweisen, deren ersten Endbereiche (29, 29') jeweils einem Leiteranschlusselement zugeordnet sind und deren zweiten Endbereiche (30, 30') so abgebogen sind, dass sie zusammen zwei federnde Kontaktbereiche (31, 32) zur Aufnahme des Kontaktsteckers (10) eines Prüfsteckers (6) bilden, wobei sich im nicht eingesteckten Zustand des Kontaktsteckers (10) die zweiten Endbereiche (30, 30') im ersten Kontaktbereich (31) kontaktieren, so dass die beiden Leiteranschlusselemente über die beiden Strombalken (9, 9') elektrisch miteinander verbunden sind, während sich die zweiten Endbereiche (30, 30') im zweiten Kontaktbereich (32) nicht berühren, so dass der zweite Kontaktbereich (32) offen ist, und wobei der zweite Kontaktbereich (32) in Aufsteckrichtung des Kontaktsteckers (10) eines Prüfsteckers (6) vor dem ersten Kontaktbereich (31) angeordnet ist.

15. Prüfklemmenblock nach einem der Ansprüche 4 bis 14, **dadurch gekennzeichnet, dass** die Kontaktstecker (10) der einzelnen Prüfstecker (6) eine unterschiedliche Länge aufweisen.

## Claims

1. Assembly comprising a fastening terminal (5) and a fastening part (7) which can be connected to a test plug block (3),
**characterized**
**in that** the terminal housing (11) of the fastening terminal (5) has at least two latching elements (16, 17) and the housing (14) of the fastening part (7) has at least two corresponding mating latching elements (18, 19), wherein the latching elements (16, 17) and the mating latching elements (18, 19) together define two latching positions of the fastening part (7) in the fastening terminal (5), the said latching positions being arranged one behind the other in the plug-mounting direction of the fastening part (7), and
**in that** an unlocking element (20) is arranged in the housing (14) of the fastening part (7) in a displaceable manner and can be moved to a first unlocking position and to a second unlocking position, wherein, in the first unlocking position, the locking of the first latching position and, in the second unlocking position, the locking of the second latching position is released by the unlocking element (20).

2. Assembly according to Claim 1, **characterized in that** latching lugs (16, 17) are formed as latching elements in the clamping housing (11) of the fastening terminal (5) and latching hooks (18, 19) are formed as mating latching elements on the housing (14) of the fastening part (7), wherein the at least one latching lug (16) of the first latching position and the at least one latching lug (17) of the second latching position are arranged on opposite sides of the clamping housing (11) and in different planes in the plug-mounting direction of the fastening part (7).

3. Assembly according to Claim 1 or 2, **characterized in that**, in the terminal housing (11) of the fastening terminal (5), two latching lugs (16, 17) are arranged on either side of the terminal housing (11), the said latching lugs each being connected to one another by means of a web (21, 22), wherein in each case one web (21, 22) is deflected by the unlocking element (20) in order to release the two latching positions.

4. Test terminal block comprising a modular terminal block (2) and a test plug block (3) which can be plug-mounted onto the modular terminal block (2), wherein the modular terminal block (2) has a plurality of modular terminals (4) which are arranged next to one another and in each case one fastening terminal (5) on either side of the plurality of modular terminals (4),
wherein the test plug block (3) has a plurality of test plugs (6) which are connected to one another and in each case one fastening part (7) on either side of the plurality of test plugs (6), wherein the two fastening parts (7) are connected to one another by means of a handle (8),
wherein each modular terminal (4) has two current bars (9) which together form a disconnecting point, and wherein each test plug (6) has a contact plug (10) which can be inserted into a disconnecting point, and
wherein the two fastening terminals (5) each have a terminal housing (11) with a receiving section (12) and the two fastening parts (7) each have a housing (14) with a corresponding insertion section (15) which can be inserted into the receiving section (12),
**characterized**
**in that** in each case one fastening terminal (5) and one fastening part (7) form an assembly according to Claim 1.

5. Test terminal block according to Claim 4, **characterized in that** the bottom edge of the unlocking element (20) sits on the top side of the terminal housing (11) of the fastening terminal (5) in the first unlocking position, and **in that** the unlocking element (20) can be moved from the first unlocking position, in the plug-mounting direction of the fastening parts (7), further into a third position, as a result of which the housing (14) of the fastening part (7) is pushed away from the terminal housing (11) of the fastening terminal (5).

6. Test terminal block according to Claim 4 or 5, **characterized in that** latching lugs (16, 17) are formed as latching elements in the terminal housing (11) of the fastening terminals (5) and latching hooks (18, 19) are formed as mating latching elements on the housing (14) of the fastening parts (7), wherein the at least one latching lug (16) of the first latching position and the at least one latching lug (17) of the second latching position are arranged on opposite sides of the terminal housing (11) and in different planes in the plug-mounting direction of the fastening parts (7).

7. Test terminal block according to Claim 6, **characterized in that**, in the terminal housing (11) of the fastening terminals (5), in each case two latching lugs (16, 17) are arranged on either side of the terminal housing (11), the said latching lugs each being connected to one another by means of a web (21, 22), wherein in each case one web (21, 22) is deflected by the unlocking element (20) in order to release the two latching positions.

8. Test terminal block according to Claim 7, **characterized in that** the unlocking elements (20) each have an operating section (23, 24) on their sides which face the webs (21, 22), wherein the first operating section (23) which serves to unlock the first latching position tapers in the plug-mounting direction of the fastening parts (7), whereas the second operating section (24) which serves to unlock the second latching position tapers counter to the plug-mounting direction of the fastening parts (7).

9. Test terminal block according to one of Claims 4 to 8, **characterized in that** the unlocking elements (20) in the housing (14) of the two fastening parts (7) are moved by a rotary motion of the handle (8).

10. Test terminal block according to Claim 9, **characterized in that** in each case one gear arrangement (25) is arranged in the housing (14) of the two fastening parts (7), the two unlocking elements (20) each being connected to the handle (8) by means of the said gear arrangement, wherein the gear arrangements (25) each preferably have two gear wheels (26, 27) and a connecting rod (28) which is connected to a gear wheel (27) at one end and to the unlocking element (20) at the other end.

11. Test terminal block according to Claim 9 or 10, **characterized in that** the unlocking elements (20) in the housing (14) of the two fastening parts (7) can be moved from a home position to the first unlocking position by virtue of a rotation of the handle (8) through an angle α in a first direction, the unlocking elements (20) can be moved to the third position by virtue of a further rotation of the handle (8) through an angle β in the same direction, and the unlocking elements (20) can be moved to the second unlocking position by virtue of turning the handle (8) back to the home position.

12. Test terminal block according to one of Claims 4 to 11, **characterized in that** the two fastening parts (7) can be mechanically connected to the test plugs (6) by means of latching pins and/or latching recesses which are arranged on the housing (14) of the fastening parts (7) and latching recesses and/or latching pins which are formed in the side wall of the housings of the test plugs (6).

13. Test terminal block according to one of Claims 4 to 12, **characterized in that** the two fastening terminals (5) can be mechanically connected to the modular terminals (4), in particular by means of latching pins and/or latching recesses which are arranged on the fastening terminals (5) and latching recesses and/or latching pins which are formed in the side wall of the terminal housings of the modular terminals (4).

14. Test terminal block according to one of Claims 4 to 13, **characterized in that** the modular terminals (4) each have at least two conductor connection elements and at least two current bars (9, 9'), the first end regions (29, 29') of the said current bars each being associated with a conductor connection element and the second end regions (30, 30') of the said current bars being bent away such that together they form two resilient contact regions (31, 32) for receiving the contact plug (10) of a test plug (6), wherein, in the state in which the contact plug (10) is not inserted, the second end regions (30, 30') make contact in the first contact region (31), so that the two conductor connection elements are electrically connected to one another by means of the two current bars (9, 9'), whereas the second end regions (30, 30') do not make contact in the second contact region (32), so that the second contact region (32) is open, and wherein the second contact region (32) is arranged in front of the first contact region (31) in the plug-mounting direction of the contact plug (10) of a test plug (6).

15. Test terminal block according to one of Claims 4 to 14, **characterized in that** the contact plugs (10) of the individual test plugs (6) have different lengths.

## Revendications

1. Assemblage constitué d'une borne de fixation (5) et d'une pièce de fixation (7) qui peut être reliée à un bloc de fiches test (3),
**caractérisé**
**en ce que** le boîtier de borne (11) de la borne de fixation (5) comporte au moins deux éléments d'encliquetage (16, 17) et en ce que le boîtier (14) de la pièce de fixation (7) comporte au moins deux éléments d'encliquetage antagonistes (18, 19), dans lequel les éléments d'encliquetage (16, 17) et les éléments d'encliquetage antagonistes (18, 19) définissent ensemble deux positions d'encliquetage de la pièce de fixation (7) dans la borne de fixation (5), disposées l'une derrière l'autre dans la direction d'enfichage de la pièce de fixation (7), et
**en ce qu'**un élément de déverrouillage (20), qui peut être amené à une première position de déverrouillage et à une deuxième position de déverrouillage, est disposé de manière coulissante dans le boîtier (14) de la pièce de fixation (7), dans lequel le verrouillage de la première position d'encliquetage, à la première position de déverrouillage, et le verrouillage de la deuxième position d'encliquetage, à la deuxième position de déverrouillage, sont libérés par l'élément de déverrouillage (20).

2. Assemblage selon la revendication 1, **caractérisé en ce que** des pattes d'encliquetage (16, 17) sont formées en tant qu'éléments d'encliquetage dans le boîtier de borne (11) de la borne de fixation (5) et **en ce que** des crochets d'encliquetage (18, 19) sont réalisés sur le boîtier (14) de la pièce de fixation (7) en tant qu'éléments d'encliquetage antagonistes, dans lequel l'au moins une patte d'encliquetage (16) de la première position d'encliquetage et l'au moins une patte d'encliquetage (17) de la deuxième position d'encliquetage sont disposées sur des côtés opposés du boîtier de borne (11) et dans des plans différents dans la direction d'enfichage de la pièce de fixation (7).

3. Assemblage selon la revendication 1 ou 2, **caractérisé en ce que** deux pattes d'encliquetage (16, 17), qui sont respectivement reliées l'une à l'autre par une entretoise (21, 22), sont disposées de chaque côté du boîtier de borne (11), dans le boîtier de borne (11) de la borne de fixation (5), dans lequel une entretoise (21, 22) respective est écartée par l'élément de déverrouillage (20) pour libérer les deux positions d'encliquetage.

4. Bornier de test comprenant un bornier (2) et un bloc de fiches de test (3) enfichable sur le bornier (2),
dans lequel le bornier (2) comporte une pluralité de blocs de jonction (4) juxtaposés et une borne de fixation (5) de chaque côté de la pluralité de blocs de jonction (4),
dans lequel le bloc de fiches de test (3) comprend une pluralité de fiches de test (6) reliées entre elles et une pièce de fixation (7) de chaque côté de la pluralité de fiches de test (6), dans lequel les deux pièces de fixation (7) sont reliées l'une à l'autre par un élément formant poignée (8),
dans lequel chaque bloc de jonction (4) comporte deux barres conductrices (9) qui forment conjointement un point de sectionnement et dans lequel chaque fiche de test (6) comporte un contact mâle (10) qui peut être enfiché dans un point de sectionnement, et
dans lequel les deux bornes de fixation (5) comportent respectivement un boîtier de borne (11) pourvu d'un réceptacle (12) et les deux pièces de fixation (7) comportent respectivement un boîtier (14) pourvu d'une partie enfichable (15) correspondante qui peut être insérée dans le réceptacle (12),
**caractérisé**
**en ce qu'**une borne de fixation (5) et une pièce de fixation (7) forment respectivement un assemblage selon la revendication 1.

5. Bornier de test selon la revendication 4, **caractérisé en ce que** le bord inférieur de l'élément de déverrouillage (20), à la première position de déverrouillage, est situé sur la face supérieure du boîtier de borne (11) de la borne de fixation (5), et **en ce que** l'élément de déverrouillage (20) est déplacé depuis la première position de déverrouillage, dans la direction d'enfichage des pièces de fixation (7), à une troisième position, de sorte que le boîtier (14) de la pièce de fixation (7) est repoussé par le boîtier de borne (11) de la borne de fixation (5).

6. Bornier de test selon la revendication 4 ou 5, **caractérisé en ce que** des pattes de verrouillage (16, 17) sont réalisées en tant qu'éléments de verrouillage dans le boîtier de borne (11) des bornes de fixation (5) et **en ce que** des crochets d'encliquetage (18, 19) sont réalisés en tant qu'éléments d'encliquetage sur le boîtier (14) des pièces de fixation (7), dans lequel l'au moins une patte d'encliquetage (16) de la première position d'encliquetage et l'au moins une patte d'encliquetage (17) de la deuxième position d'encliquetage sont disposées sur des côtés opposés du boîtier de borne (11) et dans des plans différents dans la direction d'enfichage des pièces de fixation (7).

7. Bornier de test selon la revendication 6, **caractérisé en ce que** deux pattes d'encliquetage (16, 17) qui sont reliées l'une à l'autre par une entretoise (21, 22) sont respectivement disposées de chaque côté du boîtier de borne (11), dans le boîtier de borne (11), dans lequel une entretoise (21, 22) est respectivement écartée par l'élément de déverrouillage (20) pour libérer les deux positions d'encliquetage.

8. Bornier de test selon la revendication 1, **caractérisé en ce que** les éléments de déverrouillage (20) comportent respectivement une section d'actionnement (23, 24) sur leurs côtés qui sont tournés vers les entretoises (21, 22), dans lequel la première section d'actionnement (23) servant à déverrouiller la première position d'encliquetage se rétrécit dans la direction d'enfichage des pièces de fixation (7), tandis que la deuxième section d'actionnement (24) servant à déverrouiller la deuxième position d'encliquetage se rétrécit dans une direction opposée à la direction d'enfichage des pièces de fixation (7).

9. Bornier de test selon l'une quelconque des revendications 4 à 8, **caractérisé en ce que** le déplacement des éléments de déverrouillage (20) dans le boîtier (14) des deux pièces de fixation (7) est effectué par un mouvement rotatif de l'élément formant poignée (8).

10. Bornier de test selon la revendication 9, **caractérisé en ce qu'**il est prévu, dans le boîtier (14) des deux pièces de fixation (7), un dispositif à engrenages (25) respectif par l'intermédiaire duquel les deux éléments de déverrouillage (20) sont respectivement reliés à l'élément formant poignée (8), dans lequel les dispositifs à engrenages (25) comportent de préférence deux roues dentées (26, 27) et une bielle (28) qui est reliée au niveau d'une extrémité à une roue dentée (27) et au niveau de l'autre extrémité, à l'élément de déverrouillage (20).

11. Bornier de test selon la revendication 9 ou 10, **caractérisé en ce que** les éléments de déverrouillage (20) peuvent être déplacés dans le boîtier (14) des deux pièces de fixation (7) d'une position de base à la première position de déverrouillage par une rotation de l'élément formant poignée (8) d'un angle a, **en ce que** les éléments de déverrouillage (20) peuvent être déplacés à la troisième position par une rotation supplémentaire de l'élément formant poignée (8) d'un angle β dans la même direction et **en ce que** les éléments de déverrouillage (20) peuvent être déplacés à la deuxième position de déverrouillage par une rotation de l'élément formant poignée (8) le ramenant à la position de base.

12. Bornier de test selon l'une quelconque des revendications 4 à 11, **caractérisé en ce que** les deux pièces de fixation (7) peuvent être reliées mécaniquement aux fiches de test (6) au moyen d'ergots d'encliquetage et/ou d'évidements d'encliquetage disposés sur le boîtier (14) des pièces de fixation (7) et d'évidements d'encliquetage et/ou d'ergots d'encliquetage réalisés dans la paroi latérale des boîtiers des fiches de test (6).

13. Bornier de test selon l'une quelconque des revendications 4 à 12, **caractérisé en ce que** les deux bornes de fixation (5) peuvent être reliées mécaniquement aux blocs de jonction (4), notamment au moyen d'ergots d'encliquetage et/ou d'évidements d'encliquetage disposés sur les bornes de fixation (5) et d'évidements d'encliquetage et/ou d'ergots d'encliquetage réalisés dans la paroi latérale des boîtiers de bornes des blocs de jonction (4).

14. Bornier de test selon l'une quelconque des revendications 4 à 13, **caractérisé en ce que** les blocs de jonction (4) comportent respectivement au moins deux éléments de raccordement de conducteurs et au moins deux barres conductrices (9, 9'), dont les premières zones d'extrémité (29, 29') sont respectivement associées à un élément de raccordement de conducteurs et dont les deuxièmes zones d'extrémité (30, 30') sont coudées de manière à ce qu'elles forment ensemble deux zones de contact élastiques (31, 32) pour recevoir le contact mâle (10) d'une fiche de test (6), dans lequel les deuxièmes zones d'extrémité (30, 30') sont en contact l'une avec l'autre dans la première zone de contact (31) à l'état non enfiché du contact mâle (10), de sorte que les deux éléments de raccordement des conducteurs sont reliés électriquement l'un à l'autre par les deux barres conductrices (9, 9'), tandis que les deuxièmes zones d'extrémité (30, 30') ne sont pas en contact l'une avec l'autre dans la deuxième zone de contact (32), de sorte que la deuxième zone de contact (32) est ouverte, et dans lequel la deuxième zone de contact (32) est disposée avant la première zone de contact (31) dans la direction d'enfichage du contact mâle (10) d'une fiche de test (6).

15. Bornier de test selon l'une des revendications 4 à 14, **caractérisé en ce que** le contacts mâles (10) des fiches de test (6) individuelles ont des longueurs différentes.
